(19) Europäisches Patentamt
European Patent Office
Office européen des brevets

(11) **EP 3 121 612 A1**

(12) **EUROPEAN PATENT APPLICATION**

(43) Date of publication:
**25.01.2017 Bulletin 2017/04**

(51) Int Cl.:
***G01R 31/28*** (2006.01)

(21) Application number: **15177680.4**

(22) Date of filing: **21.07.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **ABB Technology AG
8050 Zürich (CH)**

(72) Inventors:
• **Sundaramoorthy, Vinoth
5430 Wettingen (CH)**

• **Bianda, Enea
5400 Baden (CH)**
• **Bloch, Richard
6414 Oberarth (CH)**
• **Riedel, Gernot
5406 Baden-Rütihof (CH)**

(74) Representative: **ABB Patent Attorneys
C/o ABB Schweiz AG
Intellectual Property (CH-LC/IP)
Brown Boveri Strasse 6
5400 Baden (CH)**

(54) **FAILURE PREDICTION OF POWER SEMICONDUCTOR MODULES**

(57) The present invention provides a method to predict failure of power semiconductor modules (10), the power semiconductor modules (10) comprising a main emitter terminal (16) and an auxiliary emitter terminal (18), whereby the main emitter terminal (16) and the auxiliary emitter terminal (18) are connected by bond wires (24), comprising the steps of determining at least one indicator for a parasitic inductance (L3, L4) between the main emitter terminal (16) and the auxiliary emitter terminal (18), determining a threshold for the at least one indicator for the parasitic inductance (L3, L4), comparing the at least one indicator for the parasitic inductance (L3, L4) to the threshold, and indicating a failure of the power semiconductor module (10) when the at least one indicator for the parasitic inductance (L3, L4) has reached or passed the threshold. The present invention further provides a failure prediction device (40) for predicting failure of power semiconductor modules (10), the power semiconductor modules (10) comprising a main emitter terminal (16) and an auxiliary emitter terminal (18), whereby the main emitter terminal (16) and the auxiliary emitter terminal (18) are connected by bond wires (24), which is adapted to perform the above method.

FIG. 6

EP 3 121 612 A1

**Description**

**Technical Field**

The present invention relates to the area of power semiconductor modules. In particular, the present invention relates to prediction of failure of power semiconductor modules.

**Background Art**

Power semiconductor modules are used in high power applications to switch high voltages and currents and comprise multiple power semiconductors. Power semiconductors are used extensively in power electronic applications, for example motor drives or traction converters or uninterrupted power supplies.

Since each single semiconductor has a maximum voltage and current, the semiconductors are combined in parallel and/or in series within the power semiconductor module to enable the use in high power applications. Furthermore, also the power semiconductor modules can be combined in parallel and/or in series. To facilitate the manufacturing of such modules they commonly comprise multiple substrates, and the power semiconductors are mounted thereon. The substrates are provided with common contacts for emitter, collector and base contacts, so that the substrates can easily be connected in the power semiconductor modules. The substrates are mounted on a common base plate, which can be part of a housing of the power semiconductor module or which can be held within a housing of the power semiconductor module.

In nowadays power semiconductor modules, frequently four to six substrates are combined, each provided with typically four to six power semiconductors. Nevertheless, also power semiconductor modules with only one substrate can be provided. The power semiconductors comprise insulated gate bipolar transistors (IGBT), power diodes, reverse conducting insulated gate bipolar transistors (RC-IGBT), or other power semiconductors suitable for high power applications. For example, four IGBTs and two power diodes can be mounted commonly on a substrate.

The power semiconductor modules may comprise depending on its design a main emitter terminal and an auxiliary emitter terminal, which are connected to the substrates also provided with a main emitter terminal and an auxiliary emitter terminal. The main emitter terminal and the auxiliary emitter terminal are interconnected on the respective substrates by bond wires.

An important characteristic of a power semiconductor module is its lifetime. One of the major cause of failure of power semiconductor modules is the lift-off of bond wires, as this is the weak point in a power semiconductor module which is subjected to thermal cycling. When only few bond wires have lifted off, the power semiconductor module as a whole as well as the substrate with the power semiconductors mounted thereon are still operational. Typically, a high number of parallel bond wires is used to connect the power semiconductors to the substrates in order to enable the use in high power applications. Nevertheless, the power semiconductors and therefore also the substrates and the power semiconductor modules start to electrically behave in an unusual way, when bond wires have lifted off. If a power semiconductor module showing abnormal electrical patterns is allowed to continue its operation, a failure will happen at some point of time due to a reduction in safe operating area capability or other causes. In most of the cases, the failure leads to an electrical shortage between gate and emitter, so that the gate control over the power semiconductor and therefore over the entire power semiconductor module will be lost. Hence, if no counter-measure is taken in case of such a failure event, the current will continue to flow in the damaged power semiconductor module through the failed power semiconductor leading to a strong increase of its temperature. In particular, if the current is driven from an inductive load, it can be very high and the temperature increases very fast. With increasing temperature, the power semiconductor module comprising the destroyed power semiconductor will be destroyed, which may also cause damage to surrounding power semiconductor modules, in particular when an explosion of the power semiconductor and/or the power semiconductor module occurs. Still further, such an explosion can lead to a damage of further neighboring parts, which increases cost and time to repair the damage. Hence, to avoid damages, it is important to avoid the explosion of the failed power semiconductor and the respective power semiconductor module.

**Disclosure of Invention**

It is an object of the present invention to provide a method to predict failure of power semiconductor modules, which is suitable to predict failure of power semiconductor modules and to prevent damage of further components upon failure of power semiconductor modules. It is a further object of the present invention to provide a failure prediction device which reliably predicts failure of power semiconductor modules.

This object is achieved by the independent claims. Advantageous embodiments are given in the dependent claims.

In particular, the present invention provides a method to predict failure of power semiconductor modules, the power semiconductor modules comprising a main emitter terminal and an auxiliary emitter terminal, whereby the main emitter terminal and the auxiliary emitter terminal are connected by bond wires, comprising the steps of determining at least one indicator for a parasitic inductance between the main emitter terminal and the auxiliary emitter terminal, determining a threshold for the at least one indicator for the parasitic inductance, comparing the at least one indicator for the parasitic inductance to the threshold, and indicating a failure of the power semiconductor module when the at least one indicator for the parasitic inductance has reached or passed the threshold.

The present invention also provides a failure prediction device for predicting failure of power semiconductor modules, the power semiconductor modules comprising a main emitter terminal and an auxiliary emitter terminal, whereby the main emitter terminal and the auxiliary emitter terminal are connected by bond wires, whereby the failure prediction device is adapted to perform the above method.

The present invention further provides an assembly comprising a failure prediction as specified above and at least one power semiconductor module, the at least one power semiconductor module comprising a main emitter terminal and an auxiliary emitter terminal, whereby the main emitter terminal and the auxiliary emitter terminal are connected by bond wires, and the failure prediction device is connected or connectable to the at least one power semiconductor module.

The basic idea of the invention is to use the parasitic inductance between the main emitter terminal and the auxiliary emitter terminal as indicator for failure of a power semiconductor module. With the parasitic inductance as failure signal, a reliable indicator that the power semiconductor module is nearing its end of life has been found. The information about such failure precursors can be critical to improve services to existing systems, and it can also deliver a wealth of information about real operating conditions to system designers. It is further beneficial to take the parasitic inductance between the main emitter terminal and the auxiliary emitter as indicator for failure of a power semiconductor module, since this parasitic inductance can be easily measured between the main emitter terminal and the auxiliary emitter terminal.

Investigation of the changes in the parasitic inductance between the main emitter terminal and the auxiliary emitter terminal showed up that this parasitic inductance changes depending on the number of power cycles performed by the power semiconductor module. In cases where the emitter terminal is split into the main emitter terminal, also referred to as power-emitter terminal, that is connected to the power circuit and, the auxiliary emitter terminal, also referred to as Kelvin emitter terminal, that is connected to the gate drive unit, the parasitic inductance there between is accessible at gate level and can easily be determined.

The internal connections of the power semiconductor module cause amongst others the parasitic inductance between the main emitter terminal and the auxiliary emitter terminals. This is due to the bonding wires and the screwed terminals. As the power semiconductor module ages, the bond wires lift off subsequently, leading to failure of the module when a sufficient number of bond wires are lifted off. The lift off of the bond wires can be identified by an increase in the parasitic inductance between the emitter and the auxiliary inductance.

Different indicators for the parasitic inductance between the main emitter terminal and the auxiliary emitter terminal can be used. Hence, it is not required to perform a measurement of the parasitic inductance between the main emitter terminal and the auxiliary emitter terminal, as long as a threshold for the at least one indicator can be determined, which gives a reliable indication about the change in the parasitic inductance. Hence, the at least one indicator for the parasitic inductance can be compared to the threshold, so that a failure of the power semiconductor module can be indicated when the at least one indicator for the parasitic inductance has reached or passed the threshold.

According to a modified embodiment of the invention the step of determining at least one indicator for a parasitic inductance between the main emitter terminal and the auxiliary emitter terminal comprises determining a peak voltage between the main emitter terminal and the auxiliary emitter terminal. The peak voltage can be used as indicator for the parasitic inductance based on the below formula:

$$V_{EE'} = L_\sigma \frac{dI_c}{dt} \tag{1}$$

Hence, for identical signals fed between the main emitter terminal and the auxiliary emitter terminal of the power semiconductor module, the peak voltage changes when the parasitic inductance changes, so that the peak voltage can serve as an indicator for the parasitic inductance between the main emitter terminal and the auxiliary emitter terminal. Hence, the increase in the parasitic inductance can be estimated by measuring a voltage drop across the parasitic inductance. The voltage drop increases due to the increase in parasitic inductance according to above equation (1). Hence, the voltage drop across the main emitter terminal and the auxiliary emitter terminal can be used as a precursor to predict the failure of power semiconductor modules. It is apparent from equation (1), that also the rate of current rise dI/dt can be used as indicator for the parasitic inductance between the main emitter terminal and the auxiliary emitter terminal. Generally, the peak voltage is easier to detect than the current rise dI/dt, so that the peak voltage is preferred.

According to a modified embodiment of the invention the step of determining a peak voltage between the main emitter terminal and the auxiliary emitter terminal comprises determining the peak voltage between the main emitter terminal and the auxiliary emitter terminal at turn-off event. Hence, it is not required to feed a signal to the power semiconductor module for the purpose of measuring the voltage drop between the main and the auxiliary emitter terminals. The measurement can be performed during operation of the power semiconductor module based on a switching event of the power semiconductor module. Interruption of the operation of the power semiconductor module is not required. The difference between the measured voltage peak and the reference voltage peak can therefore indicate a change in the parasitic inductance, so that a simple peak detection can be performed.

According to a modified embodiment of the invention the step of determining a threshold for the at least one indicator for the parasitic inductance comprises determining the threshold using a look-up table. Depending on the type of power semiconductor module, values of the indicator can vary. Hence, when a simple detection shall be performed, which can be used for different types of power semiconductor modules, a threshold can be reliably determined based on the look-up table.

According to a modified embodiment of the invention the step of determining the threshold using a look-up table comprises determining the threshold based on load current, and/or load voltage, and/or junction temperature of an IGBT used as power semiconductor. Load current as well as load voltage as well as junction temperature of the IGBT are important parameters of power semiconductor modules. Furthermore, load current as well as load voltage as well as junction temperature of the IGBT may have impact on indicators used to determine the parasitic inductance. Hence, when load current and/or load voltage and/or junction temperature of the IGBT are given, the indicator can be reliably determined and compared to the threshold.

According to a modified embodiment of the invention the method comprises the additional step of performing a statistical evaluation of the at least one indicator for a parasitic inductance between the main emitter terminal and the auxiliary emitter terminal throughout at least parts of a lifecycle of power semiconductor modules for different load currents, and/or voltages, and/or junction temperatures of the IGBT used as power semiconductor, and storing the evaluated at least one indicator in the look-up table. This statistical approach helps to determine reliable values for the threshold for the different power semiconductor modules. Hence, the indicator and the threshold can be determined to provide a reliable means for preventing failure of power semiconductor modules.

According to a modified embodiment of the invention the step of determining a threshold for the at least one indicator for the parasitic inductance comprises determining the threshold as a relative value of the at least one indicator for the parasitic inductance at beginning of a lifecycle of a particular power semiconductor module. Based e.g. on manufacturing variances, the parasitic inductance between the main emitter terminal and the auxiliary emitter terminal can vary. Accordingly, an absolute value for the indicator for the parasitic inductance between the main emitter terminal and the auxiliary emitter terminal is typically less suitable than a relative value. Tests demonstrated that most important is a relative change of the parasitic inductance compared to the initial parasitic inductance as indication of an upcoming failure of the power semiconductor module. Accordingly, a percentage change of an initial value of the indicator at the beginning of its life time is preferred. Nevertheless, in an alternative embodiment, the threshold value can be an absolute value.

According to a modified embodiment of the invention the step of indicating a failure of the power semiconductor module comprises generating an electronic failure signal and providing the electronic failure signal to a control device. Hence, the information can be provided to a technician so that maintenance of the power semiconductor module can be performed. Typically, the power semiconductor module will be replaced in case of a detected upcoming failure. Furthermore, the information can be provided to a control device, which controls the operation of the power semiconductor module. When the power semiconductor module is used e.g. within a setup, where different power semiconductor modules can be activated independently, e.g. the power semiconductor modules are connected in parallel and activated depending on a connected load, the control device can configure the setup in a way so that usage of the power semiconductor modules is avoided or reduced. Such cases may occur e.g. in uninterrupted power supply systems with multiple converter units, whereby each converter unit comprises at least one power semiconductor module.

According to a modified embodiment of the invention the failure prediction device comprises a measurement unit for measuring a voltage between the main emitter terminal and the auxiliary emitter terminal, whereby the measurement unit is connectable to the main emitter terminal and the auxiliary emitter terminal, the failure prediction device further comprises a determination unit for determining at least one indicator for a parasitic inductance between the main emitter terminal and the auxiliary emitter terminal, the failure prediction device further comprises a look-up table with different threshold values depending on load current and/or load voltage, and/or junction temperature of an IGBT used as power semiconductor, the failure prediction device further comprises a comparator unit for comparing the at least one indicator for the parasitic inductance to the threshold from the look-up table, and the failure prediction device further comprises an indication unit for indicating a failure of the power semiconductor module when the at least one indicator for the parasitic inductance has reached or passed the threshold. The device is suitable to reliably measure the voltage between the main emitter terminal and the auxiliary emitter terminal and to implement the above described method.

According to a modified embodiment of the invention the determination unit comprises a peak voltage detection unit for determining a peak voltage between the main emitter terminal and the auxiliary emitter terminal. With the peak voltage detection unit, the peak voltage between the main emitter terminal and the auxiliary terminal can be determined to use this peak voltage as indicator for the parasitic inductance between the main emitter terminal and the auxiliary terminal. Details in respect to usage of the peak voltage as indicator for the parasitic inductance have been described above.

According to a modified embodiment of the invention the peak voltage detection unit comprises a storage element for storing the highest detected peak voltage between the main emitter terminal and the auxiliary emitter terminal. Hence, processing can be facilitated by only changing the highest detected peak voltage upon occurrence of a further increased peak voltage. Accordingly, the stored peak voltage always provides a worst case scenario, so that variations of the peak voltage, e.g. depending on operating conditions, do not dissemble a longer remaining lifetime than the lifetime to be expected according to previous, higher peak voltage values. The highest detected peak voltage or an information derived from this voltage can be provided externally as an indicator for remaining expected lifetime of a power semiconductor module, so that maintenance can be scheduled in advance to an upcoming failure indication.

According to a modified embodiment of the invention the failure prediction device comprises a multiplexing unit, which is connectable to multiple power semiconductor modules, and the multiplexing unit is adapted to select a connection to one of the multiple power semiconductor modules. The multiplexing unit enables the use of a single failure prediction device together with multiple power semiconductor modules to monitor failure of the connected power semiconductor modules. Since the changes of the parasitic inductance are rather slow, a continuous monitoring of the comparing the at least one indicator for the parasitic inductance of each and every power semiconductor module is not required. When monitoring multiple power semiconductor modules with a single failure prediction device, preferably multiple thresholds are provided, one for each power semiconductor module. Accordingly, also in case of variations of the parasitic inductance of the different power semiconductor modules, failure prediction can be reliably performed for each of the power semiconductor modules.

Brief Description of Drawings

These and other aspects of the invention will be apparent from and elucidated with reference to the embodiments described hereinafter.

In the drawings:

Fig. 1     shows a schematic view of a general power semiconductor module having parallel connected power semiconductors according to a first embodiment,

Fig. 2     shows a top view of a real power semiconductor module having one substrate with four IGBTs and 2 power diodes, which are connected in parallel, in accordance with the first embodiment,

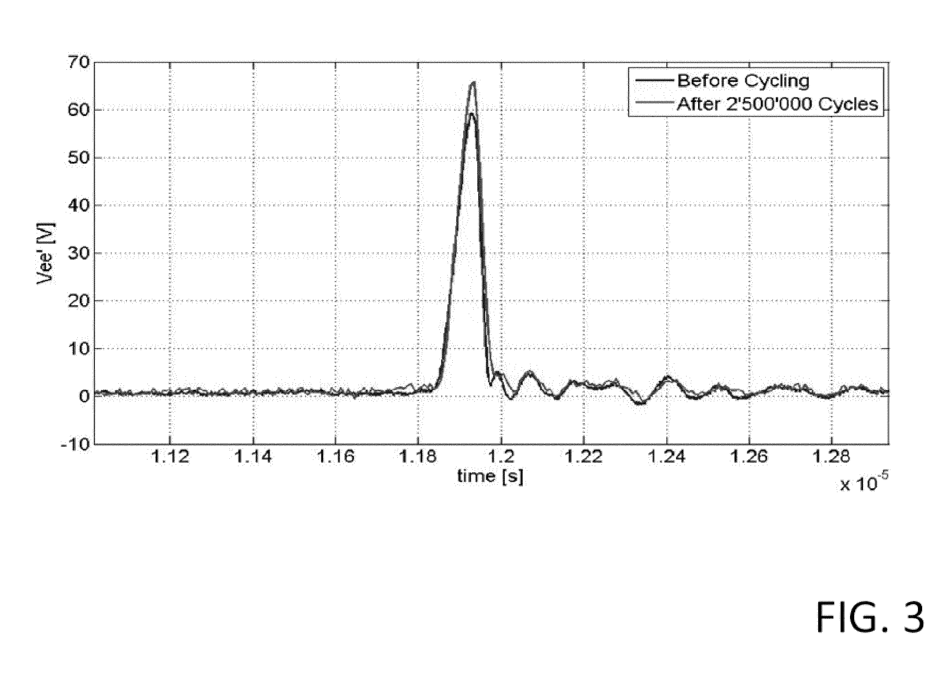

Fig. 3     shows a general curve of a voltage drop between the main emitter terminal and the auxiliary emitter terminal of the power semiconductor module at the beginning of its lifetime and after 2,500,000 cycles,

Fig. 4     shows a diagram with the parasitic inductance between the main emitter terminal and the auxiliary emitter terminal for three different power semiconductor modules at the beginning of their lifetime and after a first and a second cycling period,

Fig. 5     shows a table indicating the impact of the temperature on the parasitic inductance between the main emitter terminal and the auxiliary emitter terminal and possible indicators for the parasitic inductance at the beginning of the lifetime of a power semiconductor module and after 2,500,000 cycles,

Fig. 6     shows a block diagram illustrating the function of an apparatus for failure prediction of a power semiconductor module according to the first embodiment,

Fig. 7     shows a block diagram for an exemplary circuit implementation of a peak detector as used in the apparatus of Fig. 6,

Fig. 8     shows a detailed block diagram for an exemplary circuit implementation of a peak detector of Fig. 7, and

Fig. 9     shows a block diagram of a method to predict failure of the power semiconductor module of Figs. 1 and 2 according to the first embodiment.

Detailed Description of the Invention

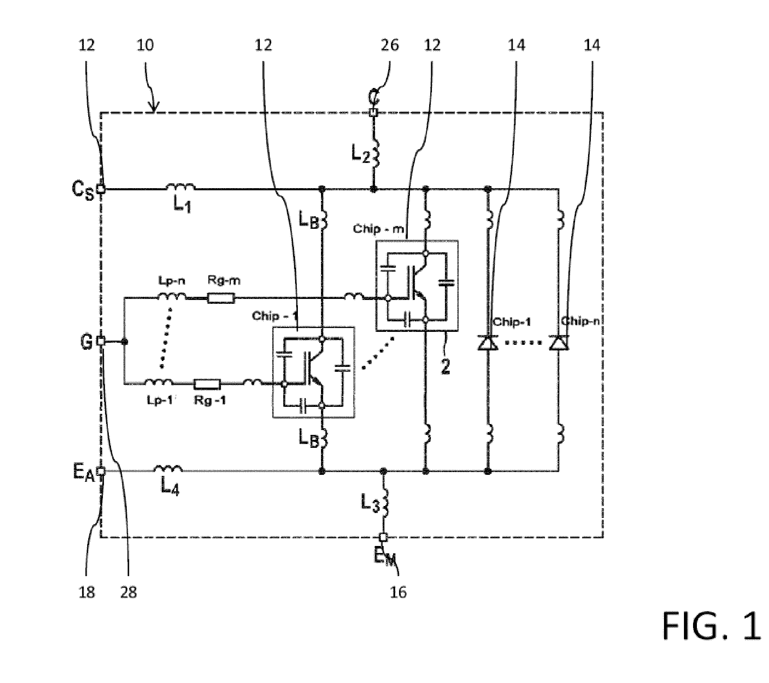

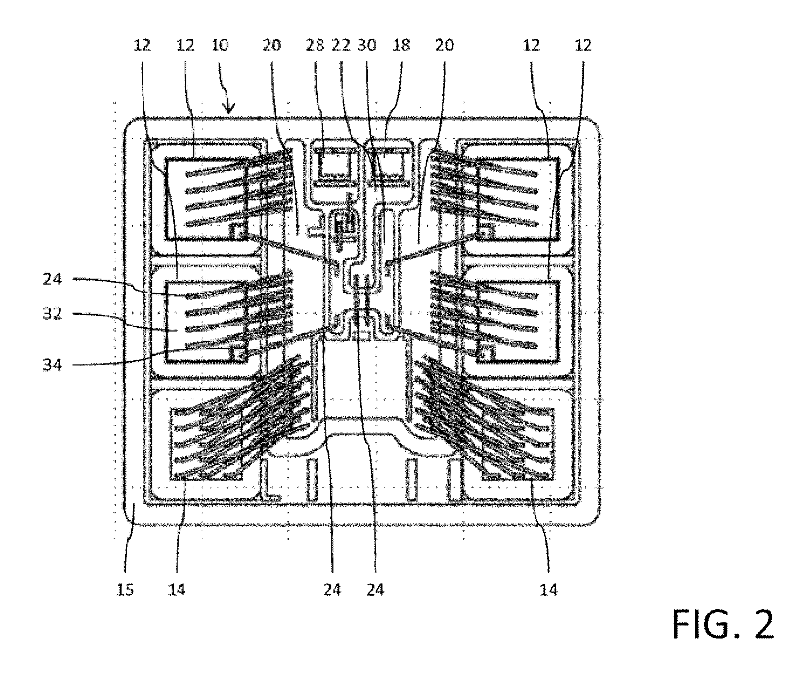

Figs. 1 and 2 refer to a power semiconductor module 10 according to a first, preferred embodiment for use in power applications, whereby Fig. 1 refer to a general view and Fig. 2 to a detailed implementation of the power semiconductor module 10. The power semiconductor module 10 comprises a number of different power semiconductors 12, 14, which are m IGBTs 12 and n power diodes 14 in this embodiment. In the more detailed view of Fig. 2, m=4 IGBTs 12 and n=2 power diodes 14 are provided in the power semiconductor module 10. The power semiconductors 12, 14 are mounted on a substrate 15. In an alternative embodiment, multiple substrates 15 with a configuration as e.g. shown in Fig. 2 are provided together to form a power semiconductor module 10.

The power semiconductor module 10 further comprises a main emitter terminal 16 and an auxiliary emitter terminal 18, which connect to a main emitter pad 20 and an auxiliary emitter pad 22, respectively. Within the power semiconductor module 10, the main emitter pad 20 and the auxiliary emitter pad 22 are interconnected by bond wires 24, as can be seen in Fig. 2. The power semiconductor module 10 further comprises a collector terminal 26 and a gate terminal 28. The gate terminal 28 is connected to a gate pad 30. The main emitter pad 20, the auxiliary emitter pad 22, and the gate pad 30 are provided on the substrate 15. Emitter contacts 32 and gate contacts 34 of the IGBTs 12 are connected by means of bond wires 24 to the main emitter pad 20 and the gate pad 30, respectively.

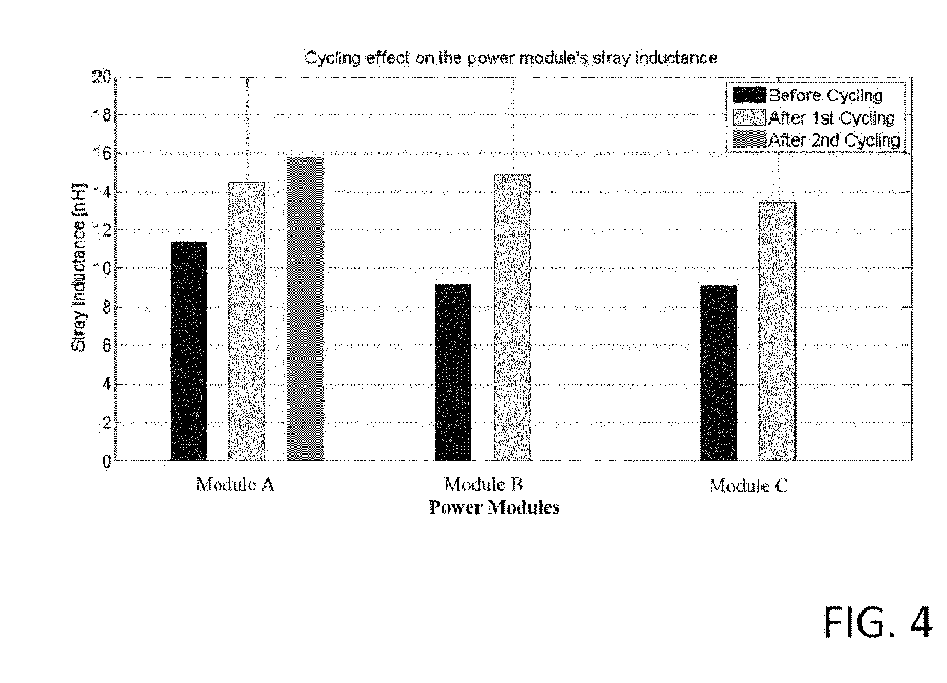

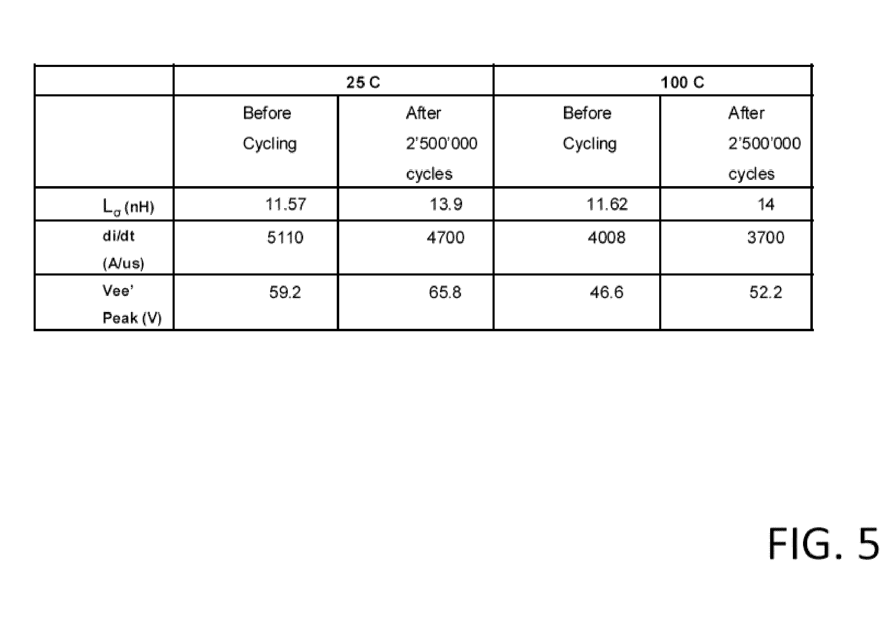

The internal connections of the power semiconductor module 10 cause different parasitic inductances L1, L2. L3, L4, LB as indicated in Fig. 1 This is due to the bond wires 24 and the different terminals 16, 18, 26, 28, which are screwed. The parasitic inductances L3, L4 refer to the parasitic inductance between the main emitter terminal 16 and the auxiliary emitter terminal 18, and will be referred to as parasitic inductance L3, L4 throughout this application, since this is the basis for the failure prediction as described further below. The parasitic inductance L3, L4 is also referred to as stray inductance in Fig. 4 and denoted as Lσ in the table of Fig. 5.

As the power semiconductor module 10 ages, the bond wires 24 lift off subsequently, leading to failure of the power semiconductor module 10 when a sufficient number of bond wires 24 are lifted off. The lift off of the bond wires 24 can be identified by an increase in the parasitic inductance L3, L4 between the main emitter terminal 16 and the auxiliary emitter terminal 18. Investigation of the changes in the parasitic inductance L3, L4 between the main emitter terminal 16 and the auxiliary emitter terminal 18 showed up that this parasitic inductance L3, L4 changes depending on the number of power cycles performed by the power semiconductor module 10. This can be seen e.g. in Fig. 4 or the table of Fig. 5. Additionally, Fig. 4 shows that the parasitic inductance L3, L4 between the main emitter terminal 16 and the auxiliary emitter terminal 18 varies between different power semiconductor modules 10. Nonetheless, the relative increase of the parasitic inductance L3, L4 until failure of the power semiconductor module 10 is similar even for the different power semiconductor modules 10 shown in Fig. 4. Furthermore, as can be seen in the table of Fig. 5, the parasitic inductance L3, L4 between the main emitter terminal 16 and the auxiliary emitter terminal 18 is essentially independent from the temperature, as can be seen from the measurements performed at 25°C and 100°C.

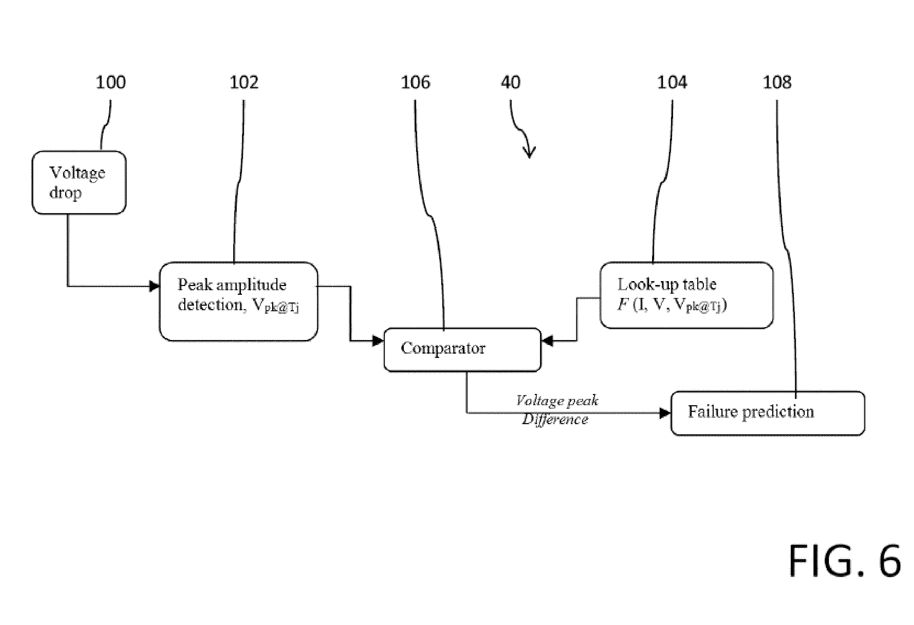

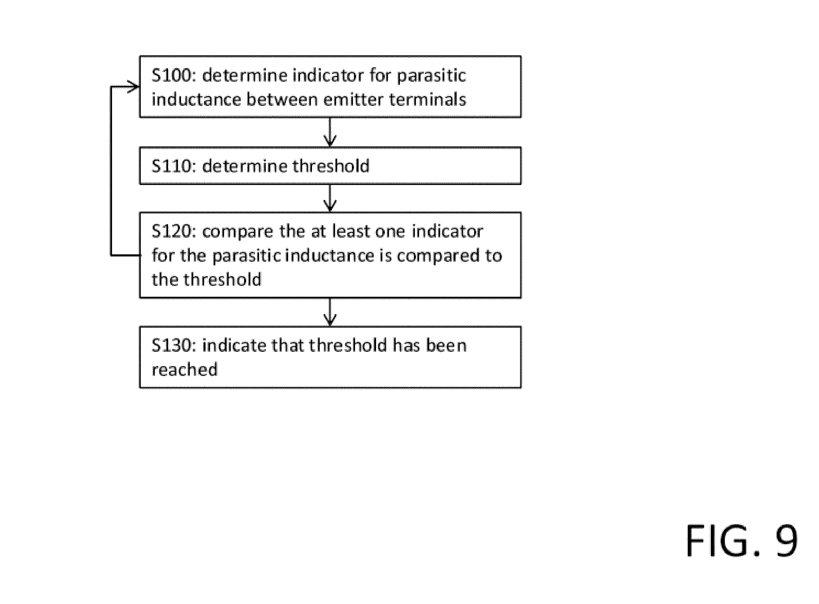

Subsequently, a method to predict failure of the power semiconductor module 10 will be described with reference to Fig. 9 under additional consideration of Fig. 6, which refers to a general failure prediction device 40.

In step S100, at least one indicator for a parasitic inductance L3, L4 between the main emitter terminal 16 and the auxiliary emitter terminal 18 is determined. The parasitic inductance L3, L4 has been found a reliable indicator as failure signal indicating that the power semiconductor module 10 is nearing its end of life. The parasitic inductance L3, L4 is considered between the main emitter terminal 16 and the auxiliary emitter terminal 18 and is determined at turn-off event of the power semiconductor module 10, i.e. during operation of the power semiconductor module 10. In this embodiment, this comprises determining a peak voltage Vee' between the main emitter terminal 16 and the auxiliary emitter terminal 18 at turn-off event, which is performed by the measurement unit 100 for measuring a voltage drop in Fig. 6, as indicator for the parasitic inductance L3, L4. A voltage drop between then main emitter terminal 16 and the auxiliary emitter terminal 18 is observed during a switching operation of the power semiconductor module 10. Subsequently, the peak voltage Vee' is determined from the measured voltage drop, corresponding to determination unit 102 with peak amplitude detection in Fig. 6. Based on the relation between the parasitic inductance L3, L4 between the peak voltage Vee', the peak voltage Vee' serves as an indicator for the parasitic inductance L3, L4 between the main emitter terminal 16 and the auxiliary emitter terminal 18 according to the formula $V_{EE}=L_\sigma \dfrac{dI_c}{dt}$ .

Since the peak voltage Vee' changes when the parasitic inductance L3, L4 changes, which is indicated by the above formula for the peak voltage Vee', the peak voltage Vee' provides a reliable precursor to predict the failure of a power semiconductor module 10.

In step S110, a threshold for the at least one indicator for the parasitic inductance L3, L4 is determined using a look-up table 104, as shown in Fig. 6. Depending on the type of power semiconductor module 10, the load current and/or the load voltage, and/or a junction temperature of the IGBT 12, or depending on other parameter variations, the parasitic inductance L3, L4 can vary. Hence, based on the look-up table 104, the threshold is determined based on the above parameters for the respective power semiconductor module 10.

The look-up table 104 is provided based on statistical evaluation of the type of power semiconductor module 10, the load current, and/or the load voltage, and/or the junction temperature of the IGBT 12, or other parameter variations for the parasitic inductance L3, L4 between the main emitter terminal 16 and the auxiliary emitter terminal 18 throughout a lifecycle of power semiconductor modules 10 for different load currents and/or voltages. The thresholds are stored in the look-up table 104 based on the evaluated at least one indicator with statistical evaluation. The thresholds in this embodiment are determined as relative values of the at least one indicator for the parasitic inductance L3, L4 at beginning of its lifecycle. Accordingly, a percentage change of the indicator at the beginning of the life time of the power semiconductor module 10 defines the threshold.

In step S120, the at least one indicator for the parasitic inductance L3, L4 is compared to the threshold. This is implemented by comparator unit 106 of Fig. 6. The comparator unit 106 compares the peak voltage Vee' between the main emitter terminal 16 and the auxiliary emitter terminal 18 with the threshold from the look-up table 104. In case the peak voltage Vee' between the main emitter terminal 16 and the auxiliary emitter terminal 18 reaches or surpasses the threshold, the method continues with step S130. Otherwise, the method returns to step S100.

In step S130, failure of the power semiconductor module 10 is indicated when the at least one indicator for the parasitic inductance L3, L4 has reached or passed the threshold. Hence, in this embodiment, an electronic failure signal is generated and provided to a control device, which is not shown in the figures. This way, the information that the at least one indicator for the parasitic inductance L3, L4 has reached or passed the threshold can be provided to a technician so that maintenance of the power semiconductor module 10 can be performed. This corresponds to the function of indication unit 108, which indicates the precursor of an upcoming failure of the power semiconductor module 10 as failure indication.

It is apparent from the above description that some of the method steps can be performed in a different order. E.g. method steps S100 and S110 can be exchanged without departing from the inventive idea. Furthermore, the step S110 can be performed only once, when the threshold is determined for the particular power semiconductor module 10 and stored. Accordingly, the look-up table 104 has to be consulted only once.

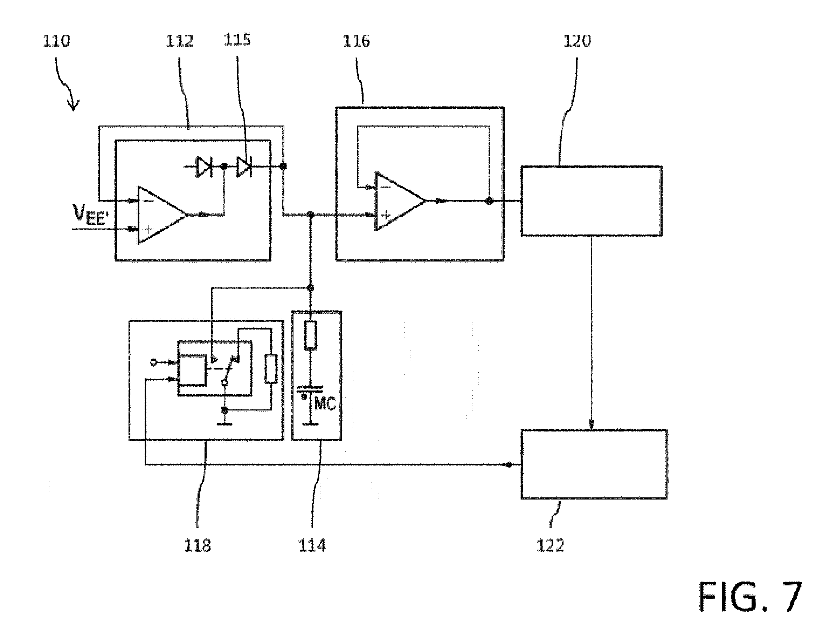

The failure prediction device 40 for predicting failure of the power semiconductor module 10, which is adapted to perform the above method, is now discussed in detail with respect to Fig. 7.

The failure prediction device 40 comprises the measurement unit 100 for measuring the voltage drop between the main emitter terminal 16 and the auxiliary emitter terminal 18. The measurement unit 100 is connected in operation to the main emitter terminal 16 and the auxiliary emitter terminal 18.

The failure prediction device 40 further comprises the determination unit 102 for determining at least one indicator for a parasitic inductance L3, L4 between the main emitter terminal 16 and the auxiliary emitter terminal 18. In this embodiment, the determination unit 102 comprises a peak voltage detection unit 110 for determining a peak voltage Vee' between the main emitter terminal 16 and the auxiliary emitter terminal 18. Details of the peak voltage detection unit 110 are discussed later with respect to Fig. 7. The peak voltage detection unit 40 comprises a storage element 114 for storing the highest detected peak voltage Vee' between the main emitter terminal 16 and the auxiliary emitter terminal 18.

The failure prediction device 40 further comprises the look-up table 104 with different threshold values depending on load current and/or load voltage, and/or a junction temperature of the IGBT 12.

The failure prediction device 40 further comprises the comparator unit 106 for comparing the at least one indicator for the parasitic inductance L3, L4 to the threshold from the look-up table 104.

Finally, the failure prediction device 40 further comprises an indication unit 108 for indicating a failure of the power semiconductor module 10 when the at least one indicator for the parasitic inductance L3, L4 has reached or passed the threshold.

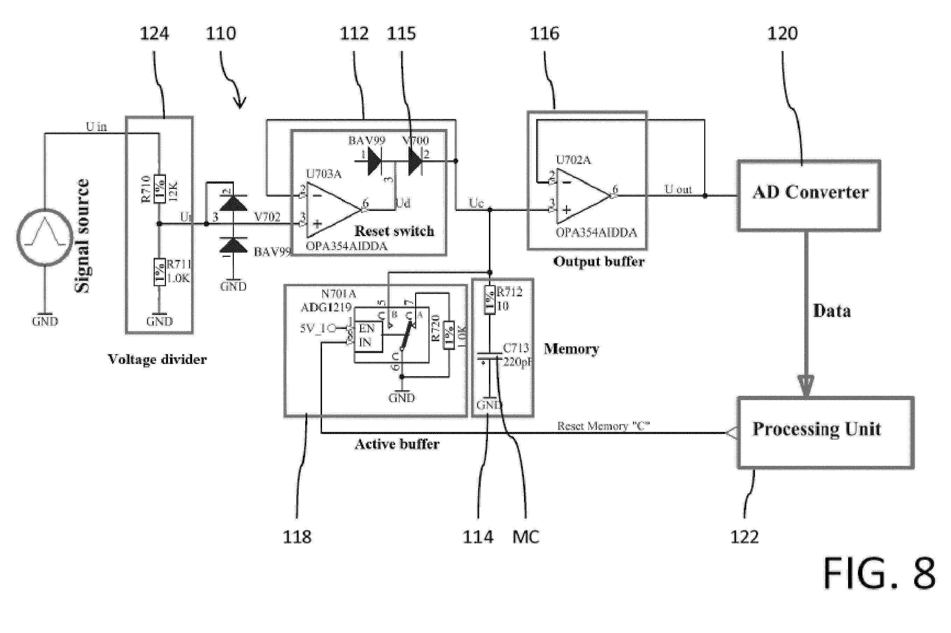

The peak voltage detection unit 110 is discussed in detail with respect to Fig. 7. The peak voltage detection unit 110 comprises an active diode block 112, which transmits the emitter voltage drop to memory capacitance block 114, which is used as the above storage element 114, through a diode 115 with a theoretical zero-voltage drop. Due to the presence of the diode 115 in the active diode block 112, a memory capacitance MC of the memory capacitance block 114 cannot discharge and retains the higher voltage. The active diode block 112 is configured to be fast enough in order to capture a small spike in the voltage drop. After reading the memory capacitance MC with an output buffer unit 116, the memory capacitance MC is reset to an initial state by means of reset unit 118. The output of the output buffer unit 116 is fed to an analog-digital converter 120 to convert the buffer output into digital data. The digital data is processed in a processing unit 122 to control the reset unit 118 for resetting the memory capacitance MC. Fig. 8 shows a detailed implementation of the peak voltage detection unit 110 as discussed in detail with respect to Fig. 7. Accordingly, an additional voltage divider 124 is provided prior to the active diode block 112, which receives the voltage drop as signal and provides the voltage drop with a level suitable for the subsequent processing to the active diode block 112.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

Reference signs list

| | |
|---|---|
| 10 | power semiconductor module |
| 12 | IGBT, power semiconductor |
| 14 | power diode, power semiconductor |
| 15 | substrate |
| 16 | main emitter terminal |
| 18 | auxiliary emitter terminal |
| 20 | main emitter pad |
| 22 | auxiliary emitter pad |
| 24 | bond wire |
| 26 | collector terminal |
| 28 | gate terminal |
| 30 | gate pad |
| 40 | failure prediction device |
| 100 | measurement unit |
| 102 | determination unit |
| 104 | look-up table |
| 106 | comparator unit |
| 108 | indication unit |
| 110 | peak voltage detection device |
| 112 | active diode block |
| 114 | memory capacitance block, storage element |
| 115 | diode |
| 116 | output buffer unit |
| 118 | reset unit |
| 120 | analog-digital converter |
| 122 | processing unit |
| 124 | voltage divider |
| MC | memory capacitance |
| | |
| L1 | parasitic inductance |
| L2 | parasitic inductance |
| L3 | parasitic inductance |
| L4 | parasitic inductance |
| LB | parasitic inductance |

**Claims**

1. Method to predict failure of power semiconductor modules (10), the power semiconductor modules (10) comprising a main emitter terminal (16) and an auxiliary emitter terminal (18), whereby the main emitter terminal (16) and the auxiliary emitter terminal (18) are connected by bond wires (24), comprising the steps of
determining at least one indicator for a parasitic inductance (L3, L4) between the main emitter terminal (16) and the auxiliary emitter terminal (18),
determining a threshold for the at least one indicator for the parasitic inductance (L3, L4),
comparing the at least one indicator for the parasitic inductance (L3, L4) to the threshold, and
indicating a failure of the power semiconductor module (10) when the at least one indicator for the parasitic inductance (L3, L4) has reached or passed the threshold.

2. Method according to claim 1,
**characterized in that**
the step of determining at least one indicator for a parasitic inductance (L3, L4) between the main emitter terminal (16) and the auxiliary emitter terminal (18) comprises determining a peak voltage (Vee') between the main emitter terminal (16) and the auxiliary emitter terminal (18).

3. Method according to claim 2,
   **characterized in that**
   the step of determining a peak voltage (Vee') between the main emitter terminal (16) and the auxiliary emitter terminal (18) comprises determining the peak voltage (Vee') between the main emitter terminal (16) and the auxiliary emitter terminal (18) at turn-off event.

4. Method according to any of preceding claims 1 to 3,
   **characterized in that**
   the step of determining a threshold for the at least one indicator for the parasitic inductance (L3, L4) comprises determining the threshold using a look-up table (104).

5. Method according to claim 4,
   **characterized in that**
   the step of determining the threshold using a look-up table (104) comprises determining the threshold based on load current, and/or load voltage, and/or junction temperature of an IGBT (12) used as power semiconductor.

6. Method according to any of preceding claims 4 or 5,
   comprising the additional step of performing a statistical evaluation of the at least one indicator for a parasitic inductance (L3, L4) between the main emitter terminal (16) and the auxiliary emitter terminal (18) throughout at least parts of a lifecycle of power semiconductor modules (10) for different load currents, and/or voltages, and/or junction temperature of an IGBT (12) used as power semiconductor, and storing the evaluated at least one indicator in the look-up table (104).

7. Method according to any preceding claim,
   **characterized in that**
   the step of determining a threshold for the at least one indicator for the parasitic inductance (L3, L4) comprises determining the threshold as a relative value of the at least one indicator for the parasitic inductance (L3, L4) at beginning of a lifecycle of a particular power semiconductor module (10).

8. Method according to any preceding claim,
   **characterized in that**
   the step of indicating a failure of the power semiconductor module (10) comprises generating an electronic failure signal and providing the electronic failure signal to a control device.

9. Failure prediction device (40) for predicting failure of power semiconductor modules (10), the power semiconductor modules (10) comprising a main emitter terminal (16) and an auxiliary emitter terminal (18), whereby the main emitter terminal (16) and the auxiliary emitter terminal (18) are connected by bond wires (24), whereby the failure prediction device (40) is adapted to perform the above method according to any of method claims 1 to 8.

10. Failure prediction device (40) according to claim 9,
    **characterized in that**
    the failure prediction device (40) comprises a measurement unit (100) for measuring a voltage between the main emitter terminal (16) and the auxiliary emitter terminal (18), whereby the measurement unit (100) is connectable to the main emitter terminal (16) and the auxiliary emitter terminal (18),
    the failure prediction device (40) further comprises a determination unit (102) for determining at least one indicator for a parasitic inductance (L3, L4) between the main emitter terminal (16) and the auxiliary emitter terminal (18),
    the failure prediction device (40) further comprises a look-up table (104) with different threshold values depending on load current, and/or load voltage, and/or junction temperature of an IGBT (12) used as power semiconductor,
    the failure prediction device (40) further comprises a comparator unit (106) for comparing the at least one indicator for the parasitic inductance (L3, L4) to the threshold from the look-up table (104), and
    the failure prediction device (40) further comprises an indication unit (108) for indicating a failure of the power semiconductor module (10) when the at least one indicator for the parasitic inductance (L3, L4) has reached or passed the threshold.

11. Failure prediction device (40) according to claim 10,
    **characterized in that**
    the determination unit (102) comprises a peak voltage detection unit (110) for determining a peak voltage (Vee') between the main emitter terminal (16) and the auxiliary emitter terminal (18).

**12.** Failure prediction device (40) according to preceding claim 10 or 11, **characterized in that**
the peak voltage detection unit (110) comprises a storage element (114) for storing the highest detected peak voltage (Vee') between the main emitter terminal (16) and the auxiliary emitter terminal (18).

**13.** Failure prediction device (40) according to any of preceding claims 10 to 12, **characterized in that**
the device comprises a multiplexing unit, which is connectable to multiple power semiconductor modules (10), and the multiplexing unit is adapted to select a connection to one of the multiple power semiconductor modules (10).

**14.** Assembly comprising a failure prediction device (40) according to any of previous claims 10 to 13 and at least one power semiconductor module (10), the at least one power semiconductor module (10) comprising a main emitter terminal (16) and an auxiliary emitter terminal (18), whereby the main emitter terminal (16) and the auxiliary emitter terminal (18) are connected by bond wires (24), and the failure prediction device (40) is connected or connectable to the at least one power semiconductor module (10).

FIG. 1

FIG. 2

EP 3 121 612 A1

FIG. 3

Cycling effect on the power module's stray inductance

FIG. 4

|  | 25 C | | 100 C | |
|---|---|---|---|---|
|  | Before Cycling | After 2'500'000 cycles | Before Cycling | After 2'500'000 cycles |
| $L_\sigma$ (nH) | 11.57 | 13.9 | 11.62 | 14 |
| di/dt (A/us) | 5110 | 4700 | 4008 | 3700 |
| Vee' Peak (V) | 59.2 | 65.8 | 46.6 | 52.2 |

FIG. 5

100 — Voltage drop

102 — Peak amplitude detection, $V_{pk@Tj}$

106 — Comparator

104 — Look-up table $F(I, V, V_{pk@Tj})$

108

*Voltage peak Difference*

Failure prediction

40

FIG. 6

FIG. 7

FIG. 8

EP 3 121 612 A1

S100: determine indicator for parasitic inductance between emitter terminals

S110: determine threshold

S120: compare the at least one indicator for the parasitic inductance is compared to the threshold

S130: indicate that threshold has been reached

FIG. 9

Europäisches Patentamt

European Patent Office

Office européen des brevets

# EUROPEAN SEARCH REPORT

Application Number

EP 15 17 7680

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 101 59 020 C1 (SEMIKRON ELEKTRONIK GMBH [DE]) 20 March 2003 (2003-03-20) <br> * paragraph [0012] - paragraph [0024] * <br> * figures 3-7 * | 1-14 | INV. <br> G01R31/28 |
| X | US 6 145 107 A (FAROKHZAD BABAK [DE]) 7 November 2000 (2000-11-07) <br> * column 1, line 53 - column 2, line 43; figures 1,2 * | 1,8,9 | |
| X | DE 102 11 831 A1 (SEMIKRON ELEKTRONIK GMBH [DE]) 9 October 2003 (2003-10-09) <br> * paragraph [0017] - paragraph [0026]; figures 3-7 * | 1,9 | |
| X | EP 1 414 066 A1 (SEMIKRON ELEKTRONIK GMBHPATENT [DE]) 28 April 2004 (2004-04-28) <br> * paragraph [0020] - paragraph [0024]; figures 3-15 * | 1,9 | |
| A | WO 2015/044205 A1 (ABB TECHNOLOGY AG [CH]) 2 April 2015 (2015-04-02) <br> * page 10, line 25 - page 11, line 3; figure 1 * <br> * page 11, line 23 - page 12, line 5 * | 3 | TECHNICAL FIELDS SEARCHED (IPC) <br><br> G01R |

The present search report has been drawn up for all claims

| Place of search | Date of completion of the search | Examiner |
|---|---|---|
| Munich | 22 January 2016 | Sedlmaier, Stefan |

## ANNEX TO THE EUROPEAN SEARCH REPORT
## ON EUROPEAN PATENT APPLICATION NO.

EP 15 17 7680

This annex lists the patent family members relating to the patent documents cited in  the above-mentioned European search report.
The members are as contained in the European Patent Office EDP file on
The European Patent Office is in no way liable for these particulars which are merely given for the purpose of information.

22-01-2016

| Patent document cited in search report | | Publication date | Patent family member(s) | | Publication date |
|---|---|---|---|---|---|
| DE 10159020 | C1 | 20-03-2003 | NONE | | |
| US 6145107 | A | 07-11-2000 | EP | 0752593 A2 | 08-01-1997 |
| | | | JP | H0936192 A | 07-02-1997 |
| | | | US | 6145107 A | 07-11-2000 |
| DE 10211831 | A1 | 09-10-2003 | NONE | | |
| EP 1414066 | A1 | 28-04-2004 | AT | 438199 T | 15-08-2009 |
| | | | DE | 10316357 A1 | 04-11-2004 |
| | | | DK | 1414066 T3 | 05-10-2009 |
| | | | EP | 1414066 A1 | 28-04-2004 |
| | | | ES | 2328124 T3 | 10-11-2009 |
| WO 2015044205 | A1 | 02-04-2015 | NONE | | |

EPO FORM P0459

For more details about this annex : see Official Journal of the European Patent Office, No. 12/82